# FASCICULE DE BREVET EUROPEEN

(11) **EP 1 914 889 B1**
(45) Date de publication et mention de la délivrance du brevet: **03.09.2014**
(21) Numéro de dépôt: 07117431.2
(22) Date de dépôt: 27.09.2007
(51) Int. Cl.: H03H 7/12

(54) **Filtre agile de puissance compact, notamment pour module d'amplification de système de radiocommunication**
Agiler Filter mit Kompaktleistung, insbesondere für Verstärkungsmodul eines Funksystems
Compact power agile filter, in particular for an amplifier module of a radio communication system

(30) Priorité: 27.09.2006 FR 0608477
(43) Date de publication de la demande: 23.04.2008
(73) Titulaire: THALES, 92200 Neuilly sur Seine (FR)
(72) Inventeur: Peyresoubes, Georges, 49300 Cholet (FR); Guillard, Olivier, 49340 Vezins (FR); Richard, Patrice, 92400 Courbevoie (FR)
(74) Mandataire: Lucas, Laurent Jacques

(56) Documents cités:
- ENTESARI K ET AL: "A DIFFERENTIAL 4-BIT 6.5-10-GHZ RF MEMS TUNABLE FILTER" IEEE TRANSACTIONS ON MICROWAVE THEORY AND TECHNIQUES, IEEE SERVICE CENTER, PISCATAWAY, NJ, US, vol. 53, no. 3, PART 2, mars 2005 (2005-03), pages 1103-1110, XP001225632 ISSN: 0018-9480
- PETERSON D A: "GaAs insertion enhances SINCGARS RF preselector" TACTICAL COMMUNICATIONS CONFERENCE, 1992. VOL. 1 TACTICAL COMMUNICATIONS: TECHNOLOGY IN TRANSITION., PROCEEDINGS OF THE FORT WAYNE, IN, USA 28-30 APRIL 1992, NEW YORK, NY, USA,IEEE, US, 28 avril 1992 (1992-04-28), pages 133-137, XP010066443 ISBN: 0-7803-0745-3

## Description

L'invention concerne un filtre agile de puissance compact. En particulier, l'invention s'applique au filtre de puissance compris dans un module d'amplification de système de radiocommunication. Par exemple, l'invention peut être utilisée par un système de radiocommunication programmable par voie logiciel s'adaptant à une gamme de signaux s'étendant sur une large plage de fréquences (dont l'étendue couvre plusieurs gigahertz). Ces modules dit logiciel peuvent encore s'adapter plus généralement à de nombreuses formes d'onde.

Les systèmes de radiocommunications comportent généralement un module amplificateur, connecté entre d'une part un module radiofréquences et d'autre part un système antennaire. La fonction d'un tel module est d'amplifier le signal utile en émission comme en réception. Plus particulièrement, le signal utile amplifié transmis via le système antennaire doit être suffisamment puissant pour atteindre la portée voulue, occupé par une bande de fréquence correspondant à la forme d'onde employée pour atteindre les performances notamment en débit souhaité, tout en respectant les contraintes normatives et réglementaires imposées.

Un module amplificateur se décompose principalement en dispositifs d'amplification de puissance du signal et en dispositifs de filtrage du signal utile. Les dispositifs de filtrage doivent s'adapter à des signaux utiles dont la forme d'onde occupe une bande passante particulièrement importante. A titre d'exemple, les systèmes logiciels de radiocommunications employant des formes d'ondes à évasion de fréquence peuvent émettre et/ou recevoir dans une plage de fréquences allant de 30 MHz à 3 GHz (soit la bande de fréquences couramment désignée par l'acronyme anglo-saxon VHF pour Very High Frequency et la bande de fréquences couramment désignée par l'acronyme anglo-saxon UHF pour Ultra High Frequency). Les dispositifs de filtrage doivent en conséquence garantir un fonctionnement compatible des formes d'ondes à évasion de fréquences, à savoir une compatibilité de la vitesse d'accord et une maîtrise du spectre émis. Les filtres dit filtres agiles permettent en particulier de répondre à cette problématique. Parmi les filtres agiles, on peut citer les filtres à poids de capacité encore appelé filtres tractables.

Le document "A Differential 4-bit 6.5-10-GHz RF MEMS Tunable Fllter", par K. Entesari et G. M. Rebeiz, IEEE Trans, on Microwave Theory and Techniques, vol. 53, No. 3, March 2005, pp. 1103-1110 décrit, par exemple, un filtre ajustable de l'état de l'art ayant des circuits oscillants couplés électromagnétiquement, l'accord du filtre se faisant à l'aide des poids de capacité.

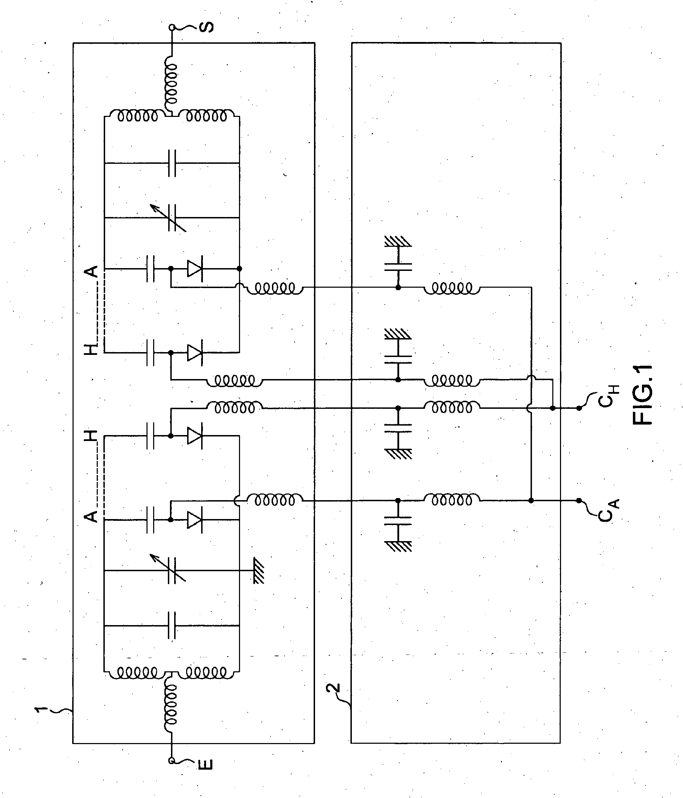

La figure 1 montre, par un synoptique, un filtre à poids de capacité selon l'état de la technique. Le filtre comprend une carte principale 1. La carte principale 1 comporte une entée E par laquelle un signal à filtrer est reçu, et une sortie S sur laquelle un signal filtré est délivré. La carte principale 1 comprend deux circuits oscillants couplés magnétiquement. La carte principale 1 comporte encore des poids de capacité (sur la figure 1, 8 poids de capacité pour chaque circuit oscillant désignés par les lettres A à H). Le nombre de poids de capacité est lié à l'étendue de la bande de fréquence couverte par filtre ainsi que la bande de fréquence intrinsèque dudit filtre. Chaque poids de capacité A..H comporte sur la figure 1 une capacité et une diode. Chaque poids de capacité est commadé par des signaux reçus d'une carte de gestion et de contrôle 2. La carte de gestion et de contrôle 2 transforme les commandes qu'elle reçoit sur des entrées C_{A}...C_{H} en commandes pour les poids de capacités A.. H. La carte de gestion et de contrôle 2 et la carte principale 1 sont généralement réalisé sur deux cartes électroniques distinctes interconnectées.

Les filtres à poids de capacité selon l'état de la technique permettent de filtrer des signaux puissants (par exemple de l'ordre de 50W), en étant agile, sélectif et limitant les pertes. Néanmoins, l'encombrement de tels filtres est problématique. Il est possible de limiter l'encombrement d'un tel filtre par l'emploi de technique de montage à 3 dimensions. Néanmoins, ce contournement induit alors un surcoût conséquent. En effet, la conception d'un tel filtre est rendue plus complexe, les procédés de fabrication plus coûteux (la fabrication et le montage étant alors au moins en partie réalisée manuellement), et la mise au point sinon délicate au moins peu reproductible d'un filtre à l'autre. Plus généralement, le problème posé est celui de la miniaturisation de ce type de filtre dans un environnement industriel automatisé sans dégrader les performances techniques d'un tel filtre.

L'invention a notamment pour but de pallier les inconvénients précités. A cet effet, l'invention a pour objet un filtre agile de puissance en bande VHF et/ou UHF à poids de capacité comprenant deux circuits oscillants couplés électromagnétiquement. Chaque circuit oscillant comporte des poids de capacité. Chaque poids de capacité est commandé par des signaux. Le filtre comporte au moins une carte mère et une carte fille physiquement distinctes. La carte fille comporte les poids de capacité, la carte mère comporte l'ensemble des circuits oscillants. Les deux cartes sont fabriquées en technologie Composants Montés en Surface.

Dans un mode de réalisation, l'interface entre la carte mère et la carte fille est assurée par un connecteur et un câblage pour les signaux radiofréquences. Le connecteur permet de faire transiter les commandes destinées au poids de capacité. Le câblage permet de faire transiter jusqu'à la carte fille des signaux radiofréquences reçus par la carte mère. Le câblage permet de faire transiter de la carte fille les signaux radiofréquences filtrés. Le câblage peut être réalisé par l'extrémité de l'inductance à l'aide de selfs à prise. Des inductances en série peuvent être disposées sur la carte mère sur une zone assurant le couplage magnétique des circuits oscillants dont la partie capacitive est compris sur la carte fille. Les inductances peuvent par exemple être des inductances à air en fil argenté.

Avantageusement, la carte fille est disposée de manière sensiblement orthogonale à la carte mère. En outre, la carte fille peut comporter des éléments de blocage disposés sur la partie basse en contact avec la carte mère, les éléments de blocages étant introduits dans des encoches en vis-à-vis disposé sur la carte mère.

Le connecteur peut être fabriqué en technologie Composants Montés en Surface. La carte fille peut être une carte double face.

Dans un mode de réalisation, la carte mère est associée à plusieurs cartes filles.

L'invention a notamment pour avantages qu'elle permet de garantir une sélectivité compatible des exigences techniques, normatives, réglementaire en terme de cosite, tout en conservant les notions de puissance et de faible encombrement. L'invention est en outre en cohérence avec les procédés de fabrication automatique mis en oeuvre aujourd'hui, comme par exemple les lignes de production dite « Composants Montés en Surface ».

D'autres caractéristiques et avantages de l'invention apparaîtront à l'aide de la description qui suit faite en regard des dessins annexés qui représentent :
- la figure 1, un synoptique d'un filtre à poids de capacité selon l'état de la technique ;
- la figure 2, un synoptique d'un filtre à poids de capacité selon l'invention ;
- la figure 3, des vues schématiques d'un exemple de réalisation d'un filtre à poids de capacité selon l'invention.

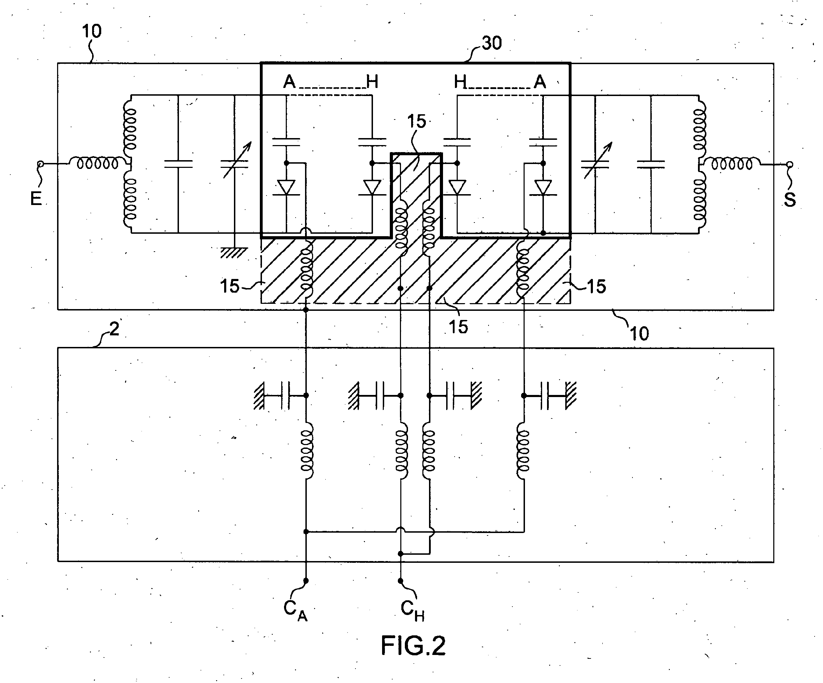

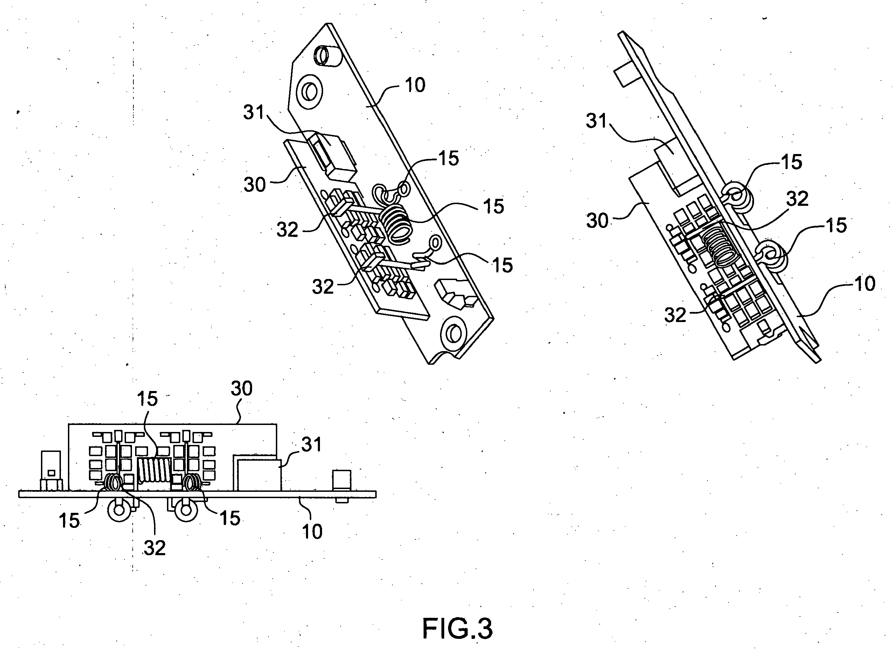

La figure 2 montre par un synoptique un filtre à poids de capacité selon l'invention. Les éléments identiques aux éléments déjà présentés sur les autres figures portent les mêmes références. Le filtre à poids de capacité selon l'invention comporte au moins deux cartes physiquement distinctes : une carte mère 10 et une carte fille 30. La carte de gestion et de contrôle 2 peut soit voir ses fonctions être intégrées sur la carte mère 10 soit constituer une troisième carte physiquement distincte des deux autres. La carte de gestion et de contrôle 2 regroupe l'ensemble des éléments participant aux fonctions de commande et d'asservissement des poids de capacité A... H. La carte fille 30 comporte quant à elle l'ensemble des éléments participant au filtrage tractable, c'est-à-dire notamment les poids de capacité A... H. La carte fille 30 ne comporte aucun élément inductif nécessaire au couplage électromagnétique. La carte fille 30 conserve la symétrie des éléments participants au filtrage tractable. La carte mère 10 comporte quant à elle l'ensemble des circuits oscillants. L'interface entre la carte mère 10 et la carte fille 30 est réalisée par un connecteur 31 et un câblage pour les signaux radiofréquences 32 (représentés à la figure 3). Le connecteur 31 permet notamment de faire transiter les commandes provenant de la carte de gestion et de contrôle 2 jusqu'à la carte fille 30, la carte mère 10 assurant le routage des signaux jusqu'au connecteur 31. Le câblage 32 permet de faire transiter jusqu'à la carte fille 30 les signaux radiofréquences reçus sur l'entrée E de la carte mère 10, et réciproquement à la carte fille 30 de délivrer des signaux radiofréquences filtrés vers la carte mère 10 qui les routera jusqu'à la sortie S. La carte mère 10 comporte une zone 15 sur laquelle sont disposés les éléments inductifs nécessaires notamment au couplage électromagnétique des circuits oscillants compris sur la carte fille 30.

La figure 3 montre des vues schématiques d'un exemple de réalisation d'un filtre à poids de capacité selon l'invention. Les éléments identiques aux éléments déjà présentés sur les autres figures portent les mêmes références. La carte fille 30 et la carte mère 10 sont des cartes fabriquées en technologie CMS (CMS pour Composants Montés en Surface). La carte fille 30 peut être une carte double face, permettant de réduire la surface nécessaire aux éléments du filtre tractable. La carte fille 30 est disposée de manière sensiblement orthogonale à la carte mère 10. La carte fille 30 peut notamment comporter des picots, des encoches ou tout autre élément de blocage disposé sur la partie basse en contact avec la carte mère 10, les éléments de blocages étant introduits dans des encoches en vis-à-vis disposé sur la carte mère 10.

Le connecteur 31 est un connecteur CMS. Le câblage 32 peut être réalisé notamment par l'extrémité de l'inductance à l'aide de self à prise. Le câblage 32 peut être aussi réalisé notamment à l'aide de câble coaxiaux. En outre, des inductances en série sont disposées sur la carte mère 10 sur la zone 15 pour assurer le couplage électromagnétique des circuits oscillants compris sur la carte fille 30. Ce choix permet notamment de simplifier le montage mécanique de la carte fille 30 sur la carte mère 10. Le choix des inductances série permet encore de faire fonctionner le filtre à qualité Q constante. En particulier, des inductances à air en fil argenté peuvent être utilisées. Ainsi, le câblage manuel du filtre se limite principalement au soudage des inductances à air en fil argenté sur la carte mère 10. La carte mère 10 peut en outre si nécessaire être associée à plusieurs cartes filles 30.

Dans un mode de réalisation, un cordon de soudure après assemblage de la carte fille 30 et de la carte principale est posé, permettant ainsi d'assurer un retour de masse optimale.
Dans un mode de réalisation, les deux circuits oscillants fonctionnent au couplage critique, caractéristique déterminable à partir notamment des coefficients de surtension des selfs comprises dans chaque circuit oscillant.

## Revendications

1. Filtre agile de puissance en bande VHF et/ou UHF à poids de capacité comprenant deux circuits oscillants couplés électromagnétiquement, chaque circuit oscillant comportant des poids de capacité (A... H), chaque poids de capacité (A... H) étant commandé par des signaux **caractérisé en ce qu'**il comporte au moins une carte mère (10) et une carte fille (30) physiquement distinctes, la carte fille (30) comportant les poids de capacité (A...H), la carte mère (10) comportant l'ensemble des circuits oscillants, la carte fille (30) et la carte mère (10) étant fabriquées en technologie Composants Montés en Surface.

2. Filtre selon la revendication 1 **caractérisé en ce que** l'interface entre la carte mère (10) et la carte fille (30) est assurée par un connecteur (31) et un câblage pour les signaux radiofréquences (32), le connecteur (31) permettant de faire transiter les commandes destinées au poids de capacité (A...H), le câblage (32) permettant de faire transiter jusqu'à la carte fille (30) des signaux radiofréquences reçus par la carte mère (10), le câblage (32) permettant de faire transiter de la carte fille (30) les signaux radiofréquences filtrés.

3. Filtre selon l'une des quelconques revendications 1 à 2 **caractérisé en ce que** le câblage (32) est réalisé par l'extrémité de l'inductance à l'aide de self à prise.

4. Filtre selon l'une des quelconques revendications 1 à 3 **caractérisé en ce que** des inductances en série sont disposées sur la carte mère (10) sur une zone (15) assurant le couplage magnétique des circuits oscillants dont la partie capacitive est comprise sur la carte fille (30).

5. Filtre selon la revendication 4 **caractérisé en ce que** les inductances sont des inductances à air en fil argenté.

6. Filtre selon l'une des quelconques revendications 1 à 5 **caractérisé en ce que** la carte fille (30) est disposée de manière sensiblement orthogonale à la carte mère (30).

7. Filtre selon la revendication 6 **caractérisé en ce que** la carte fille (30) comporte des éléments de blocage disposés sur la partie basse en contact avec la carte mère (10), les éléments de blocages étant introduits dans des encoches en vis-à-vis disposé sur la carte mère (10).

8. Filtre selon l'une des quelconques revendications 1 à 7 **caractérisé en ce que** le connecteur (31) est fabriqué en technologie Composants Montés en Surface.

9. Filtre selon l'une des quelconques revendications 1 à 8 **caractérisé en ce que** la carte fille (30) est une carte double face.

10. Filtre selon l'une des quelconques revendications 1 à 9 **caractérisé en ce que** la carte mère (10) est associée à plusieurs cartes filles (30).

## Patentansprüche

1. Agiler Leistungsfilter im VHF- und/oder UHF-Band mit Kapazitätsgewichtung, umfassend zwei elektromagnetisch gekoppelte Oszillatorschaltungen, wobei jede Oszillatorschaltung Kapazitätsgewichtungen (A...H) hat, wobei jede Kapazitätsgewichtung (A...H) durch Signale gesteuert wird, **dadurch gekennzeichnet, dass** er wenigstens eine Hauptplatine (10) und eine Tochterkarte (30) umfasst, die physisch getrennt sind, wobei die Tochterkarte (30) die Kapazitätsgewichtungen (A...H) hat, wobei die Hauptplatine (10) alle Oszillatorschaltungen umfasst, wobei die Tochterkarte (30) und die Hauptplatine (10) in SMD-Technologie gefertigt sind.

2. Filter nach Anspruch 1, **dadurch gekennzeichnet, dass** die Schnittstelle zwischen der Hauptplatine (10) und der Tochterkarte (30) durch einen Verbinder (31) und Verdrahtung (32) für die Funkfrequenzsignale gewährleistet wird, wobei der Verbinder (31) die Befehle, die für die Kapaztitätsgewichtung (A...H) bestimmt sind, durchlässt, wobei die Verdrahtung (32) von der Hauptplatine (10) empfangene Funkfrequenzsignale zur Tochterkarte (30) durchlässt, wobei die Verdrahtung (32) die gefilterten Funkfrequenzsignale von der Tochterkarte (30) durchlässt.

3. Filter nach einem der Ansprüche 1 bis 2, **dadurch gekennzeichnet, dass** die Verdrahtung (32) durch das Ende der Induktivität mit Drosselabgriff realisiert wird.

4. Filter nach einem der Ansprüche 1 bis 3, **dadurch gekennzeichnet, dass** serielle Induktivitäten auf der Hauptplatine (10) in einer Zone (15) angeordnet sind, die eine magnetische Kopplung der Oszillatorschaltungen gewährleistet, deren kapazitiver Teil sich auf der Tochterkarte (30) befindet.

5. Filter nach Anspruch 4, **dadurch gekennzeichnet, dass** die Induktivitäten Silberfaden-Luftinduktivitäten sind.

6. Filter nach einem der Ansprüche 1 bis 5, **dadurch gekennzeichnet, dass** die Tochterkarte (30) im Wesentlichen orthogonal zur Hauptplatine (10) angeordnet ist.

7. Filter nach Anspruch 6, **dadurch gekennzeichnet, dass** die Tochterkarte (30) Sperrelemente umfasst, die auf dem unteren Teil in Kontakt mit der Hauptplatine (10) angeordnet sind, wobei die Sperrelemente in auf der Hauptplatine (10) gegenüberliegend angeordneten Kerben eingesetzt sind.

8. Filter nach einem der Ansprüche 1 bis 7, **dadurch gekennzeichnet, dass** der Verbinder (31) in SMD-Technologie gefertigt ist.

9. Filter nach einem der Ansprüche 1 bis 8, **dadurch gekennzeichnet, dass** die Tochterkarte (30) eine doppelseitige Karte ist.

10. Filter nach einem der Ansprüche 1 bis 9, **dadurch gekennzeichnet, dass** die Hauptplatine (10) mit mehreren Tochterkarten (30) assoziiert ist.

## Claims

1. A capacitance-weight agile power filter in VHF and/or UHF band, comprising two electromagnetically-coupled oscillating circuits, each oscillating circuit comprising capacitance weights (A...H), each capacitance weight (A...H) being controlled by signals, **characterised in that** it comprises at least one motherboard (10) and one daughterboard (30), physically separate, the daughterboard (30) comprising the capacitance weights (A...H), the motherboard (10) comprising all the oscillating circuits, the motherboard (10) and the daughterboard (30) being manufactured using surface-mount (SMT) technology.

2. The filter according to claim 1, **characterised in that** the interface between the motherboard (10) and the daughterboard (30) is provided by a connector (31) and a wiring (32) for the radiofrequency signals, the connector (31) making it possible to convey the commands intended for the capacitance weights (A...H), the wiring (32) making it possible to convey to the daughterboard (30) radiofrequency signals received by the motherboard (10), the wiring (32) making it possible to convey from the daughterboard (30) the filtered radiofrequency signals.

3. The filter according to any one of claims 1 to 2 **characterised in that** the wiring (32) is produced by the end of the inductor using tap induction coil.

4. The filter according to any one of claims 1 to 3 **characterised in that** series inductors are disposed on the motherboard (10) over an area (15) ensuring the magnetic coupling of the oscillating circuits, the capacitive part of which is included on the daughterboard (30).

5. The filter according to claim 4, **characterised in that** the inductors are silvered wire air inductors.

6. The filter according to any one of claims 1 to 5 **characterised in that** the daughterboard (30) is disposed substantially orthogonally to the motherboard (10).

7. The filter according to claim 6, **characterised in that** the daughterboard (30) comprises immobilizing elements disposed on the bottom part in contact with the motherboard (10), the immobilizing elements being introduced into opposing notches disposed on the motherboard (10).

8. The filter according to any one of claims 1 to 7 **characterised in that** the connector (31) is manufactured using surface-mount component (SMT) technology.

9. The filter according to any one of claims 1 to 8 **characterised in that** the daughterboard (30) is a double-sided board.

10. The filter according to any one of claims 1 to 9 **characterised in that** the motherboard (10) is associated with several daughterboards (30).
